# EUROPEAN PATENT SPECIFICATION

(11) **EP 2 008 021 B1**
(45) Date of publication and mention of the grant of the patent: **30.12.2009**
(21) Application number: 07719540.2
(22) Date of filing: 16.04.2007
(51) Int. Cl.: F21V 99/00, B60Q 3/00, F21V 23/00, F21V 29/00, F21V 7/10, H01R 12/02, H05K 1/02, H05K 3/00

(54) **ILLUMINATOR**
BELEUCHTUNGSEINRICHTUNG
DISPOSITIF D'ÉCLAIRAGE

(30) Priority: 14.04.2006 US 792022 P
(43) Date of publication of application: 31.12.2008
(73) Proprietor: Intier Automotive Inc., Newmarket, Ontario L3Y 4X7 (CA)
(72) Inventor: DIXON, Mark E., Farmington Hill, Michigan 48336 (US)
(74) Representative: Hössle, Markus
(86) International application number: PCT/CA2007/000613
(87) International publication number: WO 2007/118312

(56) References cited:
- US-A- 5 463 280
- US-A- 5 585 783
- US-A- 5 949 347
- US-A1- 2002 060 526
- US-A1- 2003 102 810
- US-B1- 6 193 392
- US-B1- 6 501 084
- US-B2- 6 860 628

## Description

### FIELD OF THE INVENTION

The invention relates to an illuminator and to a system for illumination.

### BRIEF DESCRIPTION

Various industries, including among others, the automotive industry, typically incorporate illumination systems into a variety of applications. The automotive industry, for example, incorporates one or more illumination systems into vehicular cabins such that the cabin is adapted to provide light generally suitable across a range of applications, including ambient lighting for cabin aesthetics and lighting suitable for uses such as reading and the like.

Many conventional systems in the foregoing, and other applications can sometimes require light bulb replacement due to limitations inherently associated with light bulb life. A need for efficient light bulb replacement compels the automotive industry, for example, to provide an illumination system having a first, positive terminal receiver and a second, negative terminal receiver wherein each of the terminal receivers are formatted to removably retain the light bulb.

As LED technology has evolved, the automotive industry has incorporated LED lighting into vehicles, thereby replacing or enhancing conventional incandescent and halogen light bulbs. LEDs have different requirements (i.e., power requirements, heat dissipation requirements, electromagnetic interference, etc.) than the conventional illumination assemblies; and, to integrate the foregoing LED technology, the industry has designed different LED packaging and LED housings (collectively, LED systems) to accommodate the different handling associated with LED systems.

While the industry has readily incorporated LED systems into new vehicles, the conventional packaging associated with incandescent and halogen light bulbs can not easily be retrofitted to accommodate LED systems. For example, the conventional packaging can be insufficient to meet automotive standards for heat dissipation and can be inefficient in curtailing and displacing the electromagnetic radiation ("EMI") generated by the LED illumination systems.

At least some consumers may also desire to incorporate LEDs into a conventional illumination system; and, thus, there appears to be a need to replace conventional incandescent and halogen systems with the LED technology such that the conventional packaging and housings can be adapted to retrofit the LEDs while maintaining a package that meets and exceeds industry specifications.

The US 6 193 392 discloses a lighting module consisting of a circuit board supporting the electronic elements including LEDs and a reflector covering the circuit board, thereby providing openings for the LEDs penetrating the reflector, the reflector, futhermore, being bent at its edges.

### BRIEF DESCRIPTION OF THE DRAWINGS

Embodiments of the invention will now be described, by way of example, with reference to the accompanying drawings, wherein:
FIG. 1 is a perspective view of an illuminator according to an embodiment not being part of the invention;
FIG. 2 is a perspective view of a board according to an embodiment not being part of the invention;
Figure 3 is side view of an illuminator according to an embodiment not being part of the invention;
FIG. 4A is a perspective view of an illuminator according to an embodiment of the invention;
FIG. 4B is a perspective view of an illuminator according to an embodiment of the invention;
FIG. 5 is a perspective view of an illuminator according to an embodiment of the invention;
FIG. 6 is a side view of a reflector portion according to an embodiment of the invention;
FIG. 7 is a perspective view of an illuminator according to an embodiment not being part of the invention;
FIG. 8A is an exploded perspective view of an illuminator according to an embodiment not being part of the invention;
FIG. 8B is an assembled perspective view of the illuminator of FIG. 8A;
FIG. 9A is an assembled perspective view of an illuminator according to an embodiment not being part of the invention;
FIG. 9B is an assembled perspective view of the illuminator of FIG. 8B;
FIG. 10 is a perspective view of an illuminator according to an embodiment of the invention; and
FIG. 11 is side view of the illuminator of FIG. 10.

### DETAILED DESCRIPTION

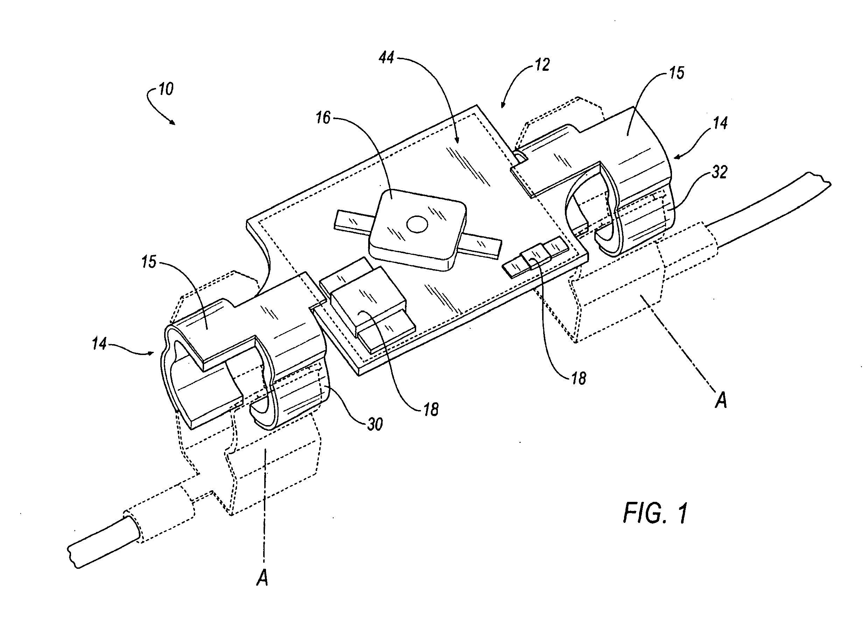

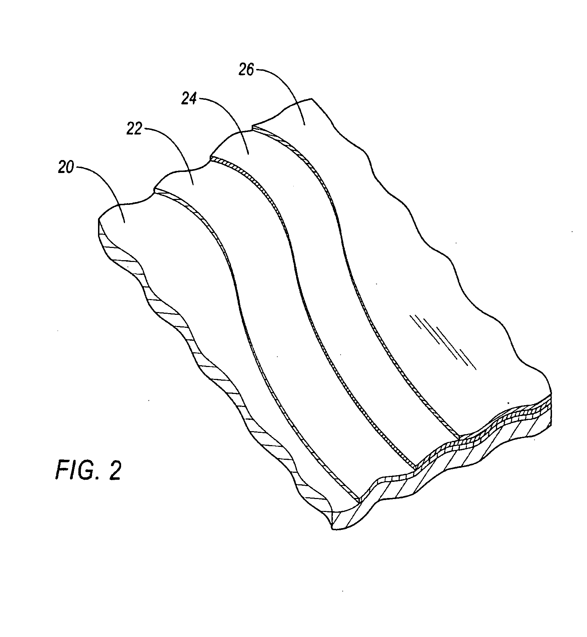

Figure 1 illustrates an exemplary illuminator 10. The illustrated illuminator 10 comprises a board 12 having one or more board interfaces 14, one or more light emitting diodes ("LED" or "LEDs") 16 electrically connected to board 12, and, if desired, circuit elements 18 in electrical communication with one or more LEDs 16 that are associated with operation of one or more LEDs 16. For purposes of convenience, the examples discussed in the disclosure hereof will reference a single LED, two circuit elements 18, and two board interfaces 14; but, it is recognized that the principles described herein can be applied by one of ordinary skill in the art to a broad range of illuminators having more than one LED, more or less than two circuit elements, and more or less than two board interfaces, and the invention should not be limited to the exemplary disclosure and illustrations. Moreover, it will be recognized that board 12 may have other unrelated elements contained thereon and the invention should not be limited to a dedicated illuminator board as described herein. Referring now to Figure 2, in an embodiment, board 12 includes a base layer 20, a dielectric layer 22, a circuit layer 24, and a top layer 26. According to the principles described herein, the inventor hereof has conceived an illuminator 10 that can be used across a broad range of packaging or housings (not shown) such that illuminator 10 can be inserted into traditional, conventional lighting systems or incorporated within new lighting systems. It will be appreciated, that, among other reasons, the invention may be desired for high efficiency and long life properties associated with LEDs.

In an embodiment, base layer 20 is thermally conductive and, while there could be additional layers there under, forms the underside of board 12. For example, among others, base layer 20 can comprise a metal such as copper or the like; but, other metals or conductors such as copper and the like may also be used therein combination or wholly replaced therefore. It is also noted that base layer 20 can comprise any size or width and the development thereof can be application specific. In an embodiment, base layer 20 may have a thickness between about 1.35mm and 1.85mm, however, the invention should not be limited to these described thicknesses. Moreover, upon considering this disclosure and the structure of the packaging or housing to which the illuminator 10 described herein may be employed, base layer 20 may be omitted from the system or replaced with dielectric material comprising a new layer or part of dielectric layer 22, such as fiberglass or otherwise. Specifically, two functions of base layer 20 are to efficiently remove by-products associated with LED lighting from circuit layer 24 and dielectric layer 22, such as heat and electromagnetic interference; and to provide means to impart shape into illuminator 10 as further outlined below.

In an embodiment, dielectric layer 22 is arranged proximate to base layer 20. Dielectric layer 22 is formatted to electrically isolate circuit layer 24 from base layer 20 and/or externalities as desired. Dielectric layer 22 may comprise a number of sublayers and the present invention should not be limited to a single layer, as illustrated. In an embodiment, dielectric layer 22 material comprises a polymer and ceramic blend formatted to achieve a low thermal impedance. In an embodiment, polymeric material, and/or its equivalent, may be incorporated into dielectric layer 22 as a means to introduce shape to board 12, as described in detail below. For example, the foregoing polymeric material and/or its equivalent has high elongation properties. Among other things, this presentation of materials can be thermoformed or stamped into a desired shape as outlined below. Polymeric material is also desired for its electrical isolation properties, while it is generally resistant to thermal aging and has a high bond strength. The ceramic material enhances thermal conductivity and can maintain a high dielectric strength. While a preferred dielectric composite is described herein, it is appreciated that other dielectric materials could be replaced therefor. In an embodiment, dielectric layer 22 also connects base layer 20 to the circuit layer 24 while electrically providing separation therebetween.

Upon considering the present disclosure, one of ordinary skill in the art will realize that the inventor hereof has conceived a board 12, comprising dielectric layer 22 and thermally conductive base layer 20, that can effectively manage the higher junction temperature that can typically result from LED driving requirements as compared to the requirements typically demanded to drive the conventional incandescent or halogen bulbs without changing the packaging or housing therearound. Specifically, the combination of a thermally conductive base layer 20 and dielectric layer 22 as described hereinabove provides means to draw the heat out of the illuminator 10 and manage electromagnetic interference such that the illuminator can be designed to meet and even exceed thermal control and electrical interference management requirements.

Circuit layer 24 provides electrically conductive traces or the like to bring power to, and lead power away from, LED 16. In an embodiment, circuit layer 24 comprises a conductor comprising a printed circuit foil, formulated from copper or the like. It is noted that conductive material other than the foregoing copper circuit foil may be used in addition to, or as a replacement for, the printed circuit foil. It should also be noted that circuit layer 24 can comprise any size or width and the development thereof is application specific. For example, circuit layer 24 may have a thickness between about 30µm and 350µm (between about 1 oz and 10 oz), however the invention should not be limited to these described thicknesses. It will be understood that trace could be formatted in any orientation and the invention hereof should not be limited to the described trace.

Top layer 26 is provided as a solder mask. Solder mask is provided over desired portions of board 12 and circuit layer 24 and, generally, provides insulative protection thereto. For example, among other possibilities, solder mask may not be provided over desired areas of circuit layer 24 such that the certain portions or areas of board 12 may be adapted to provide connection points or pads that can be used to electrically connect, via surface mount technology or otherwise, LED 16 and/or circuit elements 18 to board 12. The mounting of such elements to the foregoing pads is conventionally known and for brevity, do not form part of this disclosure. It will also be appreciated that the thickness of top layer 26 and the material used therefor is application specific and the invention described herein is thereby not limited to any material used for top layer 26. Moreover, it is appreciated that top layer 26 may be wholly omitted as well, and the invention should not be limited thereby.

While the layers are described as base layer 20, dielectric layer 22, circuit layer 24 and top layer 26, these terms are simply nomenclature of convenience and the invention should not be limited by these terms. It is further understood that there may be more than one circuit layer 24, wherein each of the circuit layers 24 may be separated by one or more dielectric layers 22. Moreover, while each of the layers are illustrated contiguous, one or more of the layers may have one or more portions not adjoined with another portion of the same layer.

Referring back to the Figures, in exemplary embodiments described herein, illuminator 10 may be adapted for insertion into conventional illumination systems that may once have supplied power to, lead power away from, and removably retained one or more conventional halogen light bulbs or incandescent light bulbs as described above. And, because the foregoing conventional illumination systems are not, generally, fully capable to appropriately handle conditions related to LED lighting, such as having effective dissipation techniques in place to handle thermal and electromagnetic phenomena that are associated with the various results typical of LED lighting, such as lower junction temperature maximums and increased electromagnetic radiation, the inventor developed a novel illuminator that can appropriately dissipate the foregoing junction and electromagnetic phenomena without necessitating a change or rework of the conventional lighting package or housing.

As previously discussed, it will also be recognized that the described embodiments can also be integrated into new illuminations systems or hybrid systems and the present invention should not be limited to retrofitting the foregoing conventional illumination systems. Thus, another benefit that may be incurred by the invention hereof is that manufacturers or the like can avoid a full re-work or retooling of equipment and related technologies, as illuminator 10 can be adapted for use with the pre-existing packaging or housings of its conventional illuminator counterparts.

Figure 1 depicts board 12 having two board interfaces 14 integrally extending below a planar portion 44 of board 12. Board interfaces 14 are shaped to removably accommodate board 12 within terminal receivers **(A).** In an embodiment, board interface 14 includes a connector 15 arranged at an exterior surface thereof. It will be appreciated that the depicted terminal receivers **(A)** are associated with the conventional incandescent and/or halogen bulbs. Upon considering the present disclosure, multiple arrangements and sizes of connector 15 will become apparent to one of ordinary skill in the art. For example, connector 15 may be arranged about the full exterior surface of board interface 14 with that caveat that electrical contact between connector 15 and thermally conductive base layer 20 is avoided. Also, connector 15 may only be arranged about a portion of board interface 14. Therefore, the present invention should not be limited to the exemplary arrangement. Moreover, any conductive material may be used for connector 15. In an embodiment, connector 15 comprises brass; however, the present invention should not be limited to this arrangement.

In an embodiment, board 12 defines a first board interface 14 including connector 15 to define a first conductive connection portion 30 in electrical arrangement with LED 16, a second board interface 14 including connector 15 to define a second conductive connection portion 32 also in electrical arrangement with LED 16. In an embodiment, first board interface 14 and second board interface 14 supply power to and receive power from board 12 via connector 15. In an embodiment, connector 15 is electrically connected to circuit layer 24 at planar portion 44 of board 12.

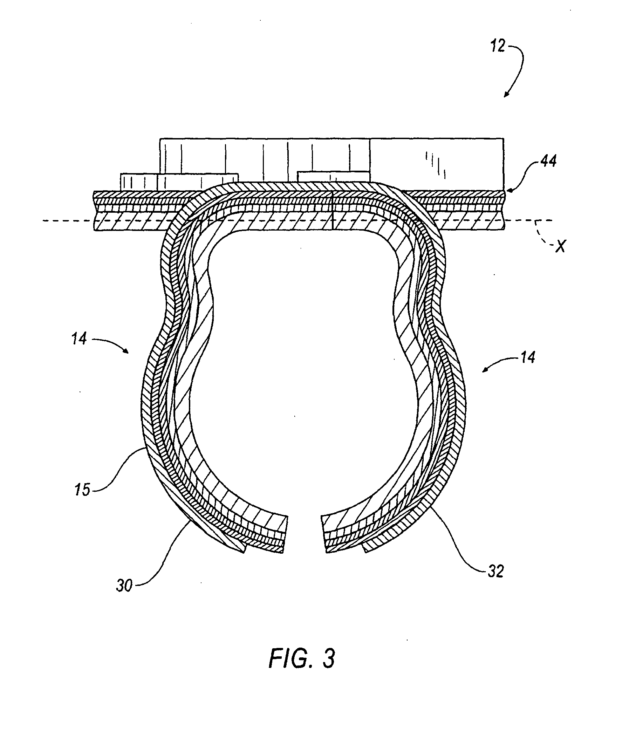

Figure 3 depicts a side sectional view of an illuminator 10 to illustrate an arrangement of board interface 14. In an embodiment, at least a portion of board interface 14 and connector 15 is displaced from a plane (X) defined by a planar portion 44 of board 12. For example, Figure 1 and Figure 3 illustrate an exemplary planar portion 44 to generally define the foregoing plane (X). In an embodiment, board interface 14 and connector 15 is shaped such that at least a portion thereof, including at least a portion of first and/or second conductive connection portion 30, 32 is displaced from plane (X).

In an embodiment, a region of board interface 14 may comprise base layer 20, dielectric layer 22, circuit layer 24 and/or top layer 26. Referring to Figure 1 and Figure 3, at least a portion of board interface 14 and connector 15 extends in a plane different than the plane defined by planar board portion 44. Thus, while the layers of board 12 are integral with planar portion 44 of board 12, they are shaped (via bending or the like) to direct a continuous conductive path (i.e., connector 15) from the respective portion 30, 32 to LED 16 and/or circuit element 18. By this configuration, board 12 is adapted to receive power directly from the terminal receiver **(A)** with minimal loss as board interface 14 is essentially integral with and extends from board 12 in the foregoing manner.

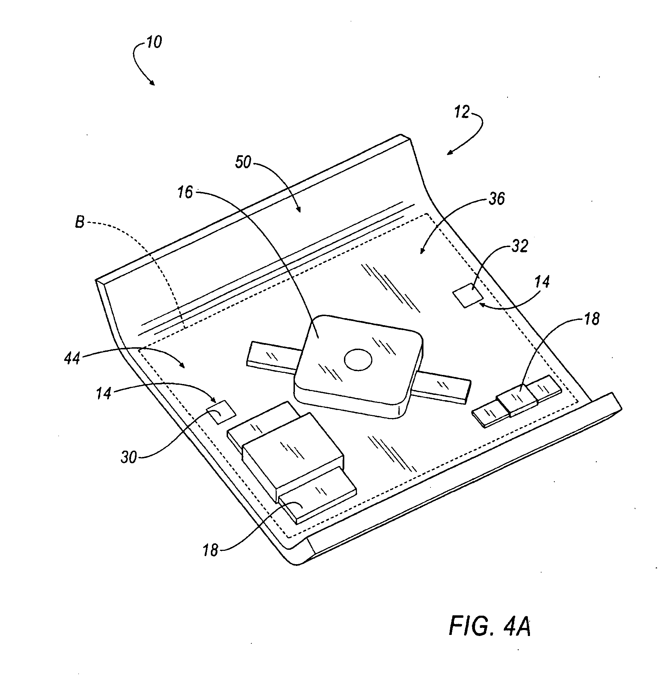

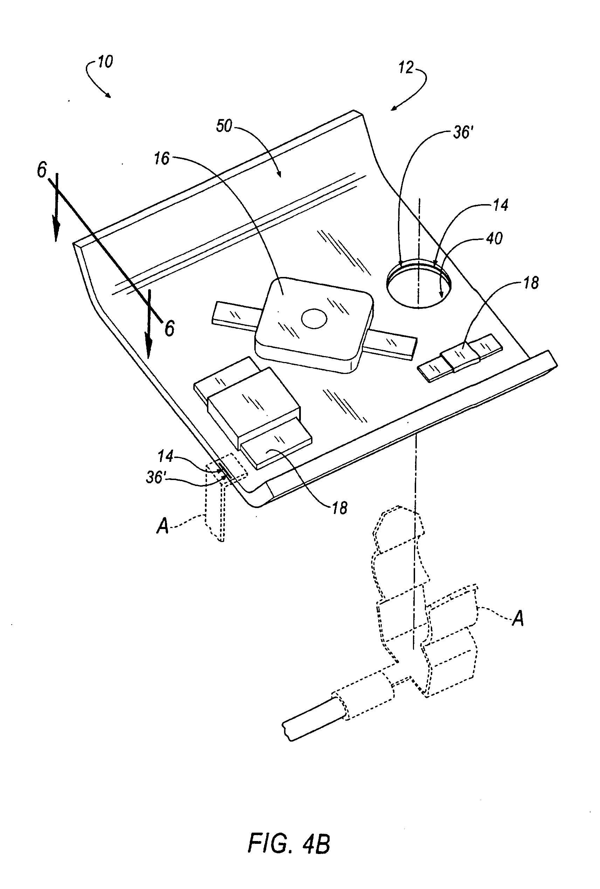

In an embodiment, referring to Figures 4A and 4B, board interfaces 14 are electrically provided on one or more surface portions 36, 36' of board 12. Figure 4A illustrates two board interfaces 14 on a top surface 36 of board 12 and Figure 4B illustrates two board interfaces 14 arranged on side surfaces 36' of board 12.

Referring now to Figure 4A, board interfaces 14 provide means to transfer power directly into and out from top surfaces 36 of board 12. A first conductive connection portion 30 and a second conductive connection portion 32 define pads on board 12. The foregoing pads can be exposed using an etching process to etch away the solder mask at pre-defined positions; but, one of ordinary skill in the art may use any known process to provide pads on the surface and the invention should not be limited to the foregoing process. Further, it will become understood that the foregoing pads can thereafter be used in conjunction with a wire, a wiring harness, directly or any other power transfer means adapted to insert and remove power from LED 16. In an embodiment, pads can be connected to external components or sources in a variety of ways; for example among others, the pads may be appropriately connected using a solder reflow process or the like. Moreover, in an embodiment wherein base 20 comprises a thermally conductive material, it may be desired to globally ensure that base 20 and all traces do not make contact. Thus, in an embodiment, traces are arranged within an inner perimeter (see dotted line marked **B)** of board 12 such that thermally conductive base layer 20 and board interface 14, along with all of the traces, are configured to avoid contact with each other. However, it will be appreciated that in a system incorporating a non-conductive base layer 20 (e.g., fiberglass or the like), board interface 14 may extend outside of this perimeter and directly contact base layer 20 and the present invention should not be unduly limited thereby.

Referring now to Figure 4B, an embodiment of board 12 is illustrated wherein the base layer 20 is non-conductive. In an embodiment, one or more traces run from one or more side surfaces 36' of board 12 to provide board interfaces 14. Specifically, Figure 4B illustrates two board interfaces 14 arranged on side surfaces 36' of board 12. In an embodiment, board interfaces 14 provide electrical connection means throughout board 12 such that power may be brought to and drawn from board 12 (via an electrical conduit as illustrated on the left side of Figure 4B or a direct connection as illustrated on the right side of Figure 4B).

In an embodiment, board 12 defines an aperture 40 such that circuit layer 22 exposes a trace that is incorporated into side surface 36' and defines a board interface 14. In this manner, terminal receiver (A) can be directly attached to trace by extending through aperture 40. Upon further considering the present disclosure, it is appreciated that side surface 36' could be provided on any side surface of board 12 and the present invention should not be limited to aperture 40 as described. For example, board interface 14 could be provided on an external surface and board 12 may or may not have an aperture defined therein. While specific configurations are disclosed, it will be appreciated that one or all of the embodiments described herein may incorporated into an illuminator and the present invention should not be limited to the disclosed orientations or combinations.

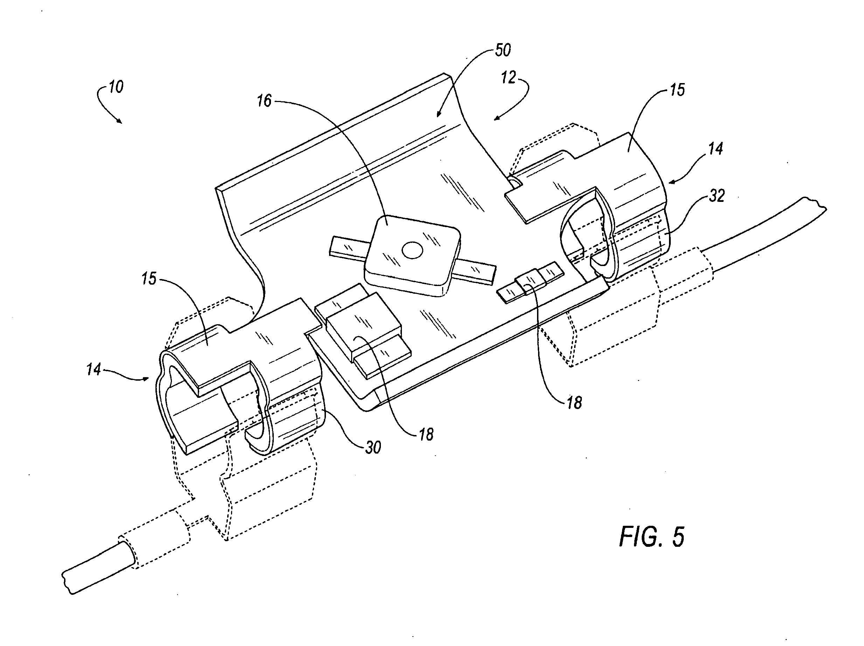

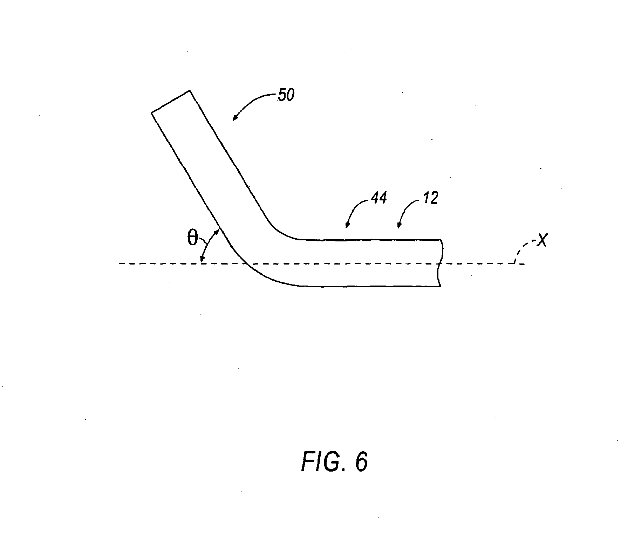

Referring now to Figure 4A, Figure 4B, and Figure 5, illuminator 10 includes traces to provide power to LED 16, circuit elements 18 and board interfaces 14 as described hereinabove. Additionally, the Figures illustrate board 12 shaped to define at least one reflector portion 50 unitary formed about and shaped from a portion of board 12. Figure 6 depicts an arrangement of reflector portion 50 shaped in and presented by board 12. Planar board portion 44 of board 12 includes a first plane (X) as depicted. At least a region of reflector portion 50 is displaced from plane (X). Figure 6 illustrates that a portion of reflector portion 50 extends from planar portion 44 at an angle θ. While a single bend is described, it will be appreciated that a complex bend to define reflector portion 50 is also contemplated. The board structure and the foregoing layer combinations, including base layer 20 and dielectric layer 22, described hereinabove provides means to allow portions of board 12 to be shaped as reflector portion 50 while maintaining layer integrity.

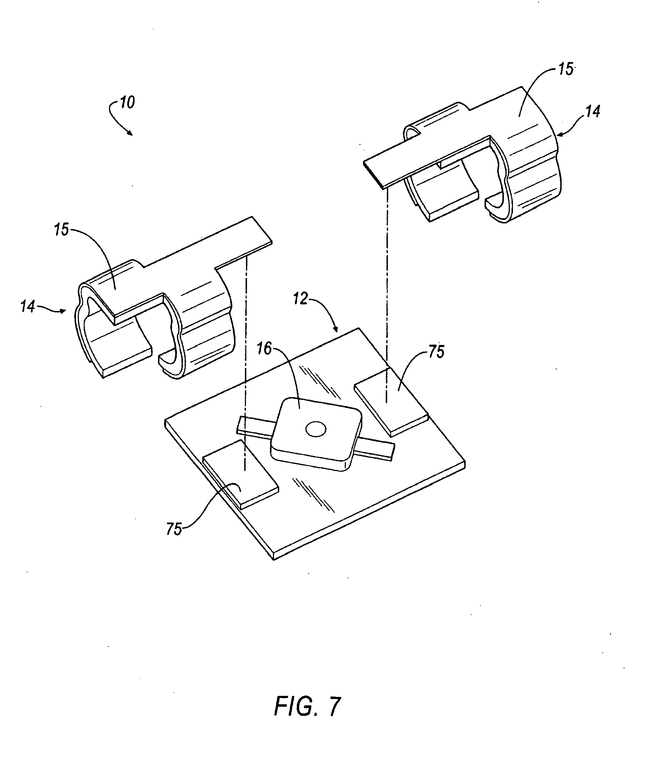

Figure 7 illustrates an exemplary illuminator 10 in accordance with the invention. The illustrated illuminator 10 comprises a board 12 having one or more separately-formed board interfaces 14 and one or more light emitting diodes ("LED" or "LEDs") 16 electrically connected to board 12. The board 12 also includes solder pads 75 that are in electrical communication with a conductive layer of the board 12 (e.g. circuit layer 24). A corresponding number of solder pads 75 may be provided to attach any desirable number of corresponding components such as, for example, interfaces 14 that are to be attached to the circuit board 12. The interfaces 14 may be attached to the circuit board 12 at the solder pads 75 by well known soldering techniques.

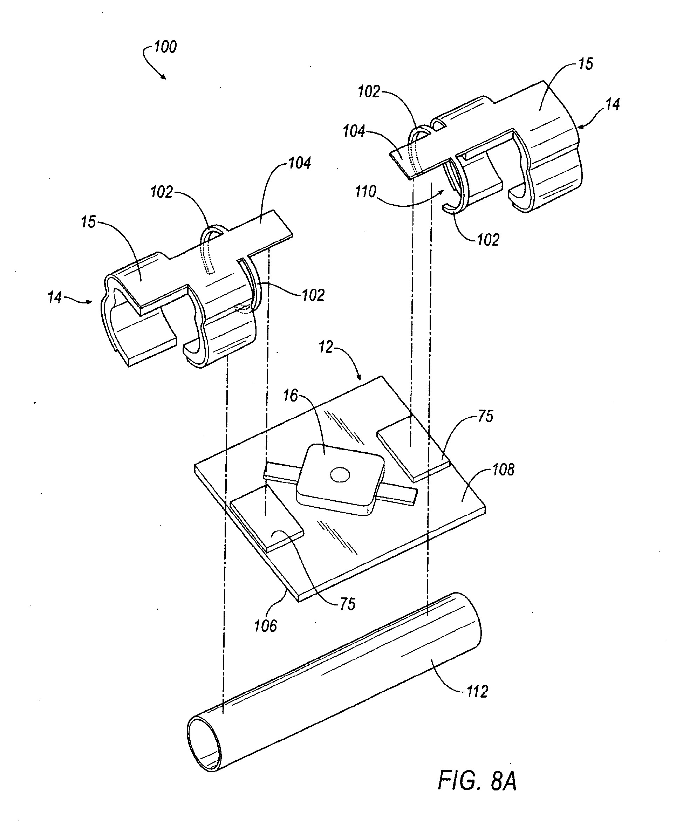

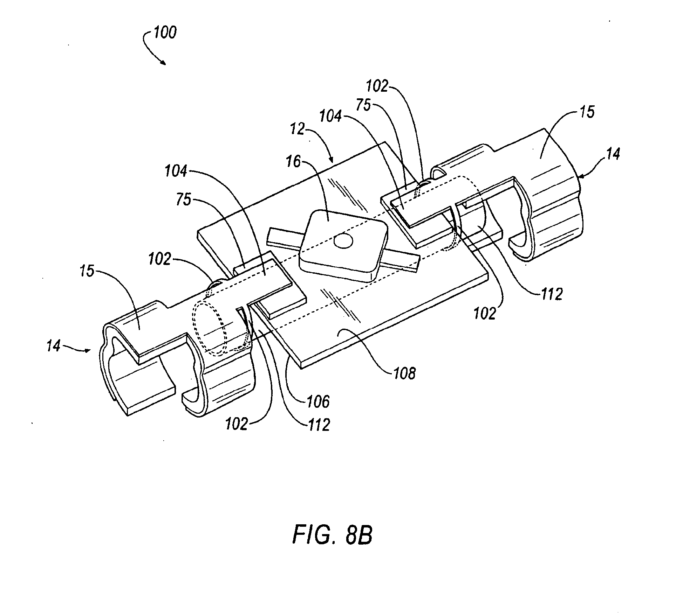

According to an embodiment, an illuminator is shown generally at 100 in Figures 8A and 8B according to an embodiment. The illuminator 100 is substantially similar to the illuminator 10 shown in Figure 7 with the exception that the illuminator 100 includes barbs or crimping portions 102 extending from tabs 104 of the connectors 15. The crimping portions 102 may be formed to include any desirable shape by any desirable forming method, such as, for example, stamping, molding, or the like. The crimping portions 102 may define a passage or opening 110 that receives structure, such as, for example, a tube 112.

As shown in Figure 8B, once attached at the solder pads 75, the crimping portions 102 may be positioned proximate a rear surface 106 of the board 12 opposite that of a front surface 108 of the board 12 that carries the LEDs 16. The tube 112 may be defined to have a length, L, that is approximately equal to, but longer than the length of the board 12. Once positioned within the passage or opening 110, the tube 112 increases the rigidity of the illuminator 100 by structurally stabilizing the connectors 15 relative the board 12.

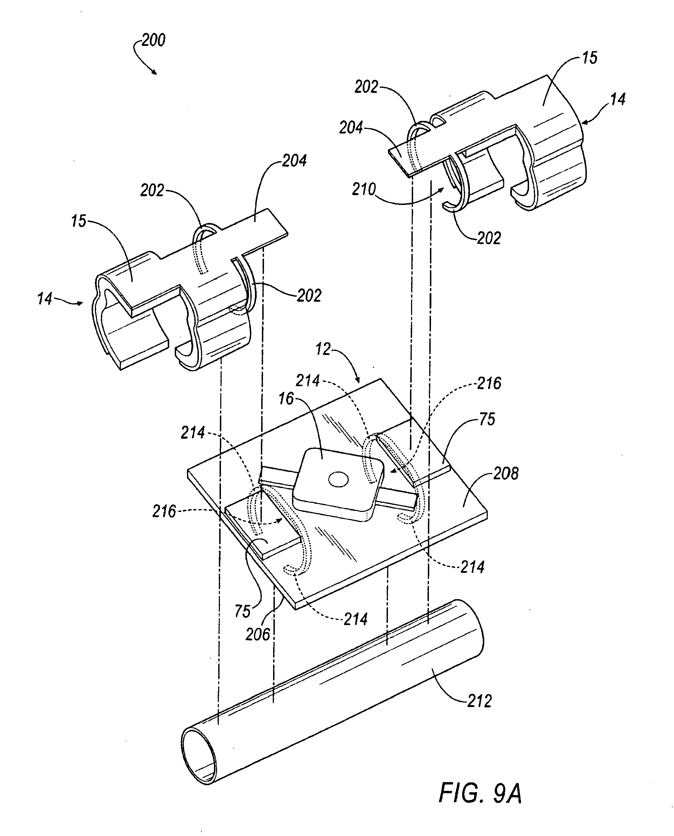

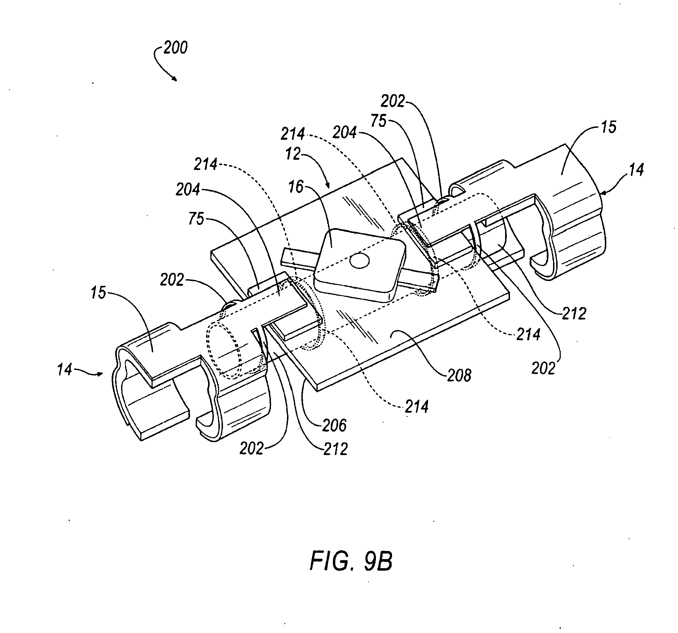

According to an embodiment, an illuminator is shown generally at 200 in Figures 9A and 9B according to an embodiment. The illuminator 200 is substantially similar to the illuminator 100 shown in Figures 8A and 8B with the exception that the board 12 includes barbs or board crimping portions 214 extending from the rear surface 206 of the board 12. The board crimping portions 214 may be formed to include any desirable shape by any desirable forming method, such as, for example, stamping, molding, or the like. The board crimping portions 214 may define a passage or opening 216 that receives structure, such as, for example, a tube 212. As similarly described above, once positioned within the passage or opening 216, the tube 212 increases the rigidity of the illuminator 200 by structurally stabilizing the connectors 15 relative the board 12.

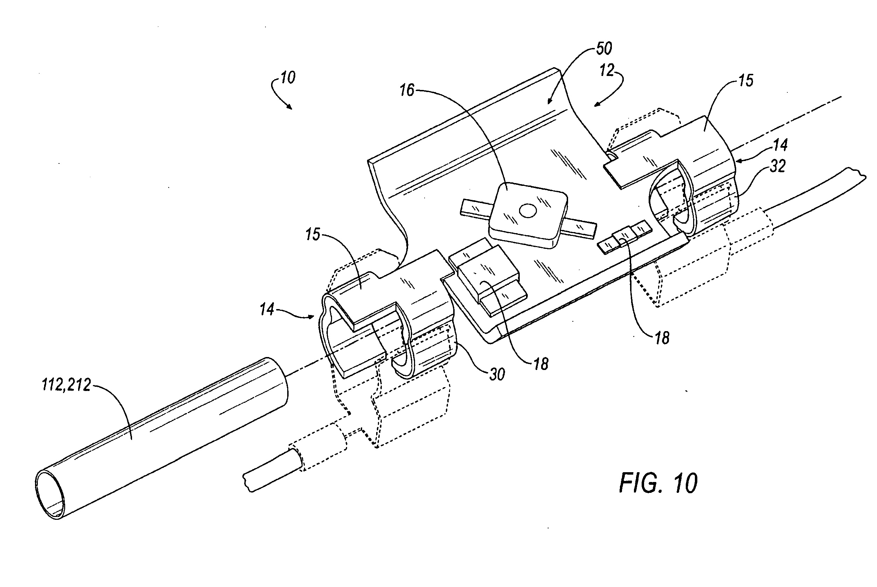

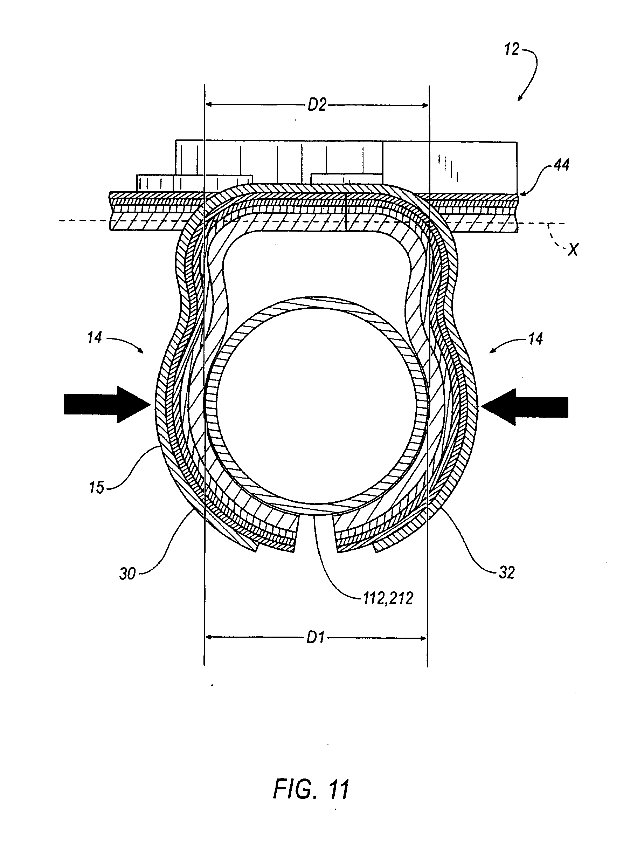

Referring to Figure 10, the tube 112, 212 of Figures 8A-9B is shown relative the illuminator 10 of Figure 5. It will be appreciated that the tube 112, 212 may also be utilized in conjunction with the illuminator 10 shown and described in any of Figures 1-7. As seen in Figure 11, the tube 112, 212 may defined by an outer diameter, D1, that is less than, but approximately equal to an inner diameter, D2, of the connector 15.

In an embodiment, at least a portion of top layer 26 is omitted or otherwise not included upon at least a portion of reflector portion 50 such that an exposed surface of reflector portion 50 comprises at least a portion of one or more of base layer 20, dielectric layer 22 and/or circuit layer 24. That is, one of the foregoing layers may be exposed and formatted to reflect the light as desired. In an embodiment, top layer 26 can be etched away from said board 12 along at least a portion of reflector portion 50 to expose or reveal one or all of the foregoing layers. For example, it may be desired to expose a conductive or metallic layer for its known reflective properties. In an embodiment, top layer 26 may never be added over at least a portion of reflector portion 50 to expose one or all of the foregoing layers such that the etching process is not needed. In an embodiment, top layer 26 is provided about reflector portion 50 such that top layer 26 may be used as reflector portion 50 instead of, or in addition to, the foregoing layers. Finally, a reflective material (such as, for example, a coating or the like) may be added to board 12 about at least a portion of reflector portion 50.

For convenience, the disclosure hereof describes and illustrates two reflector portions 50, however, one of ordinary skill in the art will readily recognize that any number of reflector portions 50 could be incorporated into illuminator using the principles described herein.

With reference to Figures 1 and 5, board 12 is shaped to define board interfaces 14 unitarily extending from board 12 at an angle such that the axis of board 12 and the axis of board interfaces 14 are arranged in different planes. As described, connector 15 is arranged about an exterior surface of board interface 14.

With reference to Figures 4A, 4B and 5, a portion of board 12 is shaped to define reflector portions 50 unitarily extending from board 12 wherein at least a portion of reflector 50 resides in a plane different from the plane defined by planar board portion 44. Thus, while conventional boards are planar and have not been adaptable to take on a shape other than planar, the inventor hereof has devised board 12 that can take on shape. For example, board 12 can be shaped to provide integral board interfaces 14 and/or integral reflector portions 50 without compromising the integrity of base layer 20, dielectric layer 22, circuit layer 24 or top layer 26. As previously described, the adaptability of board shape allows illuminator 10 to be used to retrofit a conventional incandescent or halogen light socket and, as described above, manage the byproducts associated with the LED such as increased heat and increased electromagnetic interference.

Typically, as mentioned hereinabove a bending, stamping or otherwise adding shape to an integral portion of conventional boards can result in cracking or delamination of a portion of dielectric layer 22 and thereby provides unmanageable risks thereby. Conventionally, shape could not be imparted on planar boards because, without the invention described herein, degradation results in one or more of the foregoing layers from conventional shaping processes; however, the following shaping process ensures board integrity after the shaping process. For example, conventionally, electrical contact resulting from degradation of one of the layers can ultimately short out illuminator 10 and render illuminator 10 ineffective and unusable.

In an embodiment, and as described hereinbefore, board 12 is thermoformable via the foregoing construction of layers 20, 22, 24, 26 and the following process to thereby allow shape to be imparted upon board 12 without adversely affecting circuit layer 24 and/or dielectric layer 22. In an embodiment, board 12 is stamped about this portion to form the shape of reflector 50 and/or the shape of board interface 14.

As previously described, board 12 can be shaped, via a stamping process, to create one or more board interfaces 14 having connector 15 (i.e., Figure 1 and Figure 5) and/or one or more reflector portions 50. A buffer is provided between press and at least a planar board 12 to be stamped. With reference to Figures 1 and 5, connector 15 is also used as the foregoing buffer. The pressing/stamping process acts to attach connector 15 to board 12 and thereby creates board interface 14. As this portion of board 12 becomes stamped, the foregoing attachment occurs.

Connector 15 is arranged over a portion of board 12 during this process and is adapted to directly receive a surface of press and substantially evenly disperse the stamping force associated with and incurred from press to board 12. Connector 15 and press are arranged to impart the desired board shape to define at least one of board interface 14.

In an embodiment, connector 15 is arranged substantially planar with board 12 before the stamping occurs and is arranged to directly receive at least a majority of the press surface during the stamping process. Connector 15 prevents cracking of dielectric layer 22 to ensure that base layer 20 and circuit layer 24 do not contact one another.

In an embodiment, heat may be applied to thermoform board 12 in cooperation with the foregoing stamping or shaping process, or wholly separate thereto.

In an embodiment, reflector portion 50 is formed from a heating and bending process. As described above, it is also within the present contemplation to use the foregoing stamping process to create reflector portion 50, in combination with a heating and bending or wholly separate therefrom. It is noted that the buffer may be incorporated into the reflector; however, the invention should not be limited thereby such that the buffer may be reused for additional manufacturing. Moreover, while a particular reflector shape is illustrated, it will be appreciated that reflector 50 could comprise any shape and the present invention should not be limited to the exemplary, illustrated shape.

The present invention has been particularly shown and described with reference to the foregoing embodiments, which are merely illustrative of the best modes for carrying out the invention. It should be understood by those skilled in the art that various alternatives to the embodiments of the invention described herein may be employed in practicing the invention without departing from the scope of the invention as defined in the following claims. It is intended that the following claims define the scope of the invention and that the method and apparatus within the scope of these claims and their equivalents be covered thereby. This description of the invention should be understood to include all novel and non-obvious combinations of elements described herein, and claims may be presented in this or a later application to any novel and non-obvious combination of these elements. Moreover, the foregoing embodiments are illustrative, and no single feature or element is essential to all possible combinations that may be claimed in this or a later application.

In the following, a list of numbered aspects of the invention is recited.
1. An illuminator (10) comprising: a circuit board (12) including a planar board portion (44) and a board portion non-planar to said planar board portion (44), and wherein said board portion non- planar to said planar board portion (44) defines one of a board interface (14) and a reflector (50).
2. The illuminator (10) according to aspect 1, wherein both of said board interface (14) and said reflector (50) are defined by said board portion non-planar to said planar board portion (44).
3. The illuminator (10) according to aspect 1, wherein the circuit board includes a dielectric layer (22), a circuit layer (24), and an insulative solder mask top layer (26).
4. The illuminator (10) according to aspect 3 further comprising a thermally conductive base layer (20) that removes heat and electromagnetic interference from said circuit layer (24) and dielectric layer (22).
5. The illuminator (10) according to aspect 4, wherein the dielectric layer (22) includes a polymer and ceramic blend of material that achieves a low thermal impedance while electrically isolating said circuit layer (24) from said base layer (20).
6. The illuminator (10) according to aspect 3, wherein the circuit layer (24) includes an electrical conductor trace to power a component (16, 18) disposed on the circuit board (12).
7. The illuminator (10) according to aspect 6, wherein said component (16) is defined to include one or more light emitting diodes.
8. The illuminator (10) according to aspect 7, wherein said circuit board (12) including said one or more light emitting diodes (16) is adaptable to replace an incandescent light source component or incandescent light source circuit arrangement.
9. The illuminator (10) according to aspect 3 further comprising an absence of said insulative solder mask top layer (26) that exposes one or more portions of said circuit layer (24) to provide one or more connection points or pads (30, 32) for providing electrical surface-mount connection locations (36) for one or more surface components to be attached to said board (12).
10. The illuminator (10) according to aspect 1 , wherein said board interface (14) defines a connector (15) for removable connection with a terminal receiver (A).
11. The illuminator (10) according to aspect 10, wherein a side surface (36') of said circuit board (12) defines the connector (15).
12. The illuminator (10) according to aspect 11, wherein said side surface (36') is an exterior side surface of the circuit board (12).
13. The illuminator (10) according to aspect 11, wherein said side surface (36') is an interior side surface defined by an aperture (40) formed in the circuit board (12).
14. The illuminator (10) according to aspect 3, wherein the reflector (50) is defined by an absence of, or, an etched portion of the top layer (26) to expose a conductive or metallic layer disposed under the top layer (26).
15. The illuminator (10) according to aspect 3, wherein the reflector (50) is defined by a layer of reflective material added to the top layer (26) of the circuit board (12).
16. The illuminator (10) according to aspect 1 further comprising one or more solder pads (75) that are in electrical communication with the circuit board (12) for attaching one or more interfaces (14) to the circuit board (12).
17. The illuminator (100, 200) according to aspect 1 further comprising: one or more crimping portions (102, 202) extending from tabs (104, 204) of the connectors (15); and structure (112, 212) that is received by a passage or opening (110, 210) defined by the one or more crimping portions (102, 202) that increases the rigidity of the illuminator (100, 200) by structurally stabilizing the connectors (15) relative the board (12).
18. The illuminator (200) according to aspect 17 further comprising: one or more board crimping portions (214) extending from a rear surface (206) of the board (12), wherein said structure (212) is received by a passage or opening (216) defined by the one or more board crimping portions (214) that further increases the rigidity of the illuminator (200) by structurally stabilizing the connectors (15) relative the board (12).
19. A method for manufacturing an illuminator (10), comprising the steps of: providing a circuit board (12) with a first portion and a second portion; shaping the first portion to define a substantially planar circuit board portion (44); and shaping the second portion to a substantially non-planar circuit board portion defined by a board interface (14), and a reflector (50).
20. The method according to aspect 19, wherein the shaping the second portion step includes the steps of defining a connector (15) by heating the second portion; and bending the second portion.
21. The method according to aspect 19, wherein the shaping the second portion step includes the step of defining a connector (15) by stamping the second portion.
22. The method according to aspect 19, wherein the shaping the second portion step includes the step of defining a connector (15) by bending the second portion.
23. The method according to aspect 19, wherein the shaping the first portion step includes the step of defining a connector (15) by providing an aperture (40) in the circuit board (12).
24. The method according to aspect 19, wherein the providing a circuit board (12) step includes the step of providing an insulative solder mask top layer (26).
25. The method according to aspect 24 further comprising the step of providing a circuit layer (24) that includes an electrical conductor trace to power a component (16, 18).
26. The method according to aspect 23, wherein said component is defined to include one or more light emitting diodes (16) and further comprising the step of replacing an incandescent light source component or incandescent light source circuit with said circuit board (12) including said one or more light emitting diodes (16).
27. The method according to aspect 25 further comprising the step of providing an absence of said insulative solder mask top layer (26) to exposes one or more portions of said circuit layer (24) to provide one or more connection points or pads (30, 32) for providing electrical surface-mount connection locations (36) for one or more surface components to be attached to said board (12).
28. The method according to aspect 24 further comprising the step of providing an absence of the top layer (26) to expose a conductive or metallic layer disposed under the top layer (26) to define the reflector (50).
29. The method according to aspect 24 further comprising the step of etching the top layer (26) to expose a conductive or metallic layer disposed under the top layer (26) to define the reflector (50).
30. The method according to aspect 24 further comprising the step of providing a layer of reflective material to the top layer (26) to define the reflector (50).

## Claims

1. An illuminator (10) comprising: a circuit board (12) including a planar board portion (44) and a board portion non-planar to said planar board portion (44), **characterised in that** said board portion non- planar to said planar board portion (44) defines one of a board interface (14) and a reflector (50).

2. The illuminator (10) according to claim 1, wherein both of said board interface (14) and said reflector (50) are defined by said board portion non-planar to said planar board portion (44).

3. The illuminator (10) according to claim 1, wherein the circuit board includes a dielectric layer (22), a circuit layer (24), and an insulative solder mask top layer (26).

4. The illuminator (10) according to claim 3 further comprising a thermally conductive base layer (20) that removes heat and electromagnetic interference from said circuit layer (24) and dielectric layer (22).

5. The illuminator (10) according to claim 3, wherein the circuit layer (24) includes an electrical conductor trace to power a component (16, 18) disposed on the circuit board (12).

6. The illuminator (10) according to claim 5, wherein said component (16) is defined to include one or more light emitting diodes.

7. The illuminator (10) according to claim 6, wherein said circuit board (12) including said one or more light emitting diodes (16) is adaptable to replace an incandescent light source component or incandescent light source circuit arrangement.

8. The illuminator (10) according to claim 3 further comprising an absence of said insulative solder mask top' layer (26) that exposes one or more portions of said circuit layer (24) to provide one or more connection points or pads (30, 32) for providing electrical surface-mount connection locations (36) for one or more surface components to be attached to said board (12).

9. The illuminator (100, 200) according to claim 1 further comprising: a connector (15), one or more crimping portions (102, 202) extending from tabs (104, 204) of the connectors (15); and structure (112, 212) that is received by a passage or opening (110, 210) defined by the one or more crimping portions (102, 202) that increases the rigidity of the illuminator (100, 200) by structurally stabilizing the connectors (15) relative the board (12).

10. A method for manufacturing an illuminator (10), comprising the steps of: providing a circuit board (12) with a first portion and a second portion; shaping the first portion to define a substantially planar circuit board portion (44); and shaping the second portion to a substantially non-planar circuit board portion defined by a board interface (14), and a reflector (50).

11. The method according to claim 10, wherein the providing a circuit board (12) step includes the step of providing an insulative solder mask top layer (26).

12. The method according to claim 11 further comprising the step of providing a circuit layer (24) that includes an electrical conductor trace to power a component (16, 18).

13. The method according to claim 13, wherein said component is defined to include one or more light emitting diodes (16) and further comprising the step of replacing an incandescent light source component or incandescent light source circuit with said circuit board (12) including said one or more light emitting diodes (16).

14. The method according to claim 11 further comprising the step of providing an absence of the top layer (26) or etching the top layer (26) to expose a conductive or metallic layer disposed under the top layer (26) to define the reflector (50).

15. The method according to claim 11 further comprising the step of providing a layer of reflective material to the top layer (26) to define the reflector (50).

## Patentansprüche

1. Beleuchtungseinrichtung (10) mit einer Leiterplatine (12), die einen ebenen Platinenabschnitt (44) und einen zu dem ebenen Platinenabschnitt (44) nicht-eben angeordneten Platinenabschnitt umfasst, **dadurch gekennzeichnet, dass** der zu dem ebenen Platinenabschnitt nicht-eben angeordnete Platinenabschnitt eine Platinenschnittstelle (14) oder einen Reflektor (50) definiert.

2. Beleuchtungseinrichtung (10) nach Anspruch 1, bei der sowohl die Platinenschnittstelle (14) als auch der Reflektor (50) von dem zu dem ebenen Platinenabschnitt (44) nicht-eben angeordneten Platinenabschnitt definiert werden.

3. Beleuchtungseinrichtung (10) nach Anspruch 1, bei der die Leiterplatine eine dielektrische bzw. nichtleitende Schicht (22), eine Leitungsschicht (24) und eine isolierende Lötstoppmasken-Deckschicht (26) umfasst.

4. Beleuchtungseinrichtung (10) nach Anspruch 3, die außerdem eine wärmeleitende Grundschicht (20) umfasst, die Wärme und elektromagnetische Interferenzen bzw. Störungen von der Leitungsschicht (24) und der dielektrischen Schicht (22) abführt.

5. Beleuchtungseinrichtung (10) nach Anspruch 3, bei der die Leitungsschicht (24) eine elektrische Leiterbahn zum Versorgen einer auf der Leiterplatine (12) angeordneten Komponente (16, 18) mit Energie umfasst.

6. Beleuchtungseinrichtung (10) nach Anspruch 5, bei der die Komponente (16) eine oder mehrere lichtemittierende Dioden umfasst.

7. Beleuchtungseinrichtung (10) nach Anspruch 6, bei der die eine oder mehrere lichtemittierende Dioden (16) umfassende Leiterplatine (12) dazu angepasst ist, eine glühende Lichtquellenkomponente oder eine glühende Lichtquellenschaltungsanordnung zu ersetzen.

8. Beleuchtungseinrichtung (10) nach Anspruch 3, die des weiteren eine Abwesenheit der isolierten Lötstoppmasken-Deckschicht (26) umfasst, die einen oder mehrere Abschnitte der Leiterplatine (24) zum Bereitstellen eines oder mehrerer Verbindungspunkte oder einer oder mehrerer Verbindungsflächen (30, 32) freigibt, um elektrische Verbindungsstellen (36) zur Befestigung auf der Oberfläche für eine oder mehrere Oberflächenkomponenten bereitzustellen, die auf der Platine (12) zu befestigen sind.

9. Beleuchtungseinrichtung (100, 200) nach Anspruch 1, die des weiteren ein Verbindungsstück (15), einen oder mehrere sich von Laschen (104, 204) der Verbindungsstücke (15) weg erstreckende, gekrümmte bzw. gewundene Abschnitte (102, 202) und eine Struktur (112, 212) umfasst, wobei die Struktur (112, 212) von einem Durchlass oder einer Öffnung (110, 210) aufgenommen wird, die von dem einen oder den mehreren gekrümmten Abschnitten (102, 202) definiert werden, und die Steifigkeit der Beleuchtungseinrichtung (100, 200) durch strukturelles Stabilisieren der Verbindungsstücke (15) bezüglich der Platine (12) erhöht.

10. Verfahren zum Herstellen einer Beleuchtungseinrichtung (10) mit den folgenden Schritten: Bereitstellen einer Leiterplatine (12) mit einem ersten Abschnitt und einem zweiten Abschnitt, Ausformen des ersten Abschnitts zum Definieren eines im wesentlichen ebenen Leiterplatinenabschnitts (44) und Ausformen des zweiten Abschnitts zu einem im wesentlichen nicht-ebenen Leiterplatinenabschnitt, der durch eine Platinenschnittstelle (14) und einen Reflektor (50) definiert wird.

11. Verfahren nach Anspruch 10, bei dem der Schritt des Bereitstellens einer Leiterplatine (12) den Schritt des Bereitstellens einer isolierenden Lötstoppmasken-Deckschicht (26) umfasst.

12. Verfahren nach Anspruch 11, das des weiteren den Schritt des Bereitstellens einer Leitungsschicht (24) umfasst, die eine elektrische Leiterbahn zum Versorgen einer Komponente (16, 18) mit Energie umfasst.

13. Verfahren nach Anspruch 10, bei dem die Komponente eine oder mehrere lichtemittieren Dioden (16) umfasst und das Verfahren des weiteren den Schritt des Ersetzens einer glühenden Lichtquellenkomponente oder einer glühenden Lichtquellenschaltung durch die die eine oder mehreren lichtemittierenden Dioden (16) umfassende Leiterplatine (12) umfasst.

14. Verfahren nach Anspruch 11, das des weiteren den Schritt des Bereitstellens einer Abwesenheit der Deckschicht (26) oder des Ätzens der Deckschicht (26) zum Freilegen einer unter der Deckschicht (26) angeordneten Leitungs- oder metallischen Schicht umfasst, um den Reflektor (50) zu definieren.

15. Verfahren nach Anspruch 11, das des weiteren den Schritt des Bereitstellens einer Schicht aus reflektierendem Material an der Deckschicht (26) umfasst, um einen Reflektor (50) zu definieren.

## Revendications

1. Dispositif d'éclairage (10) comprenant : une carte à circuits (12) incluant une portion en carte plane (44) et une portion en carte non plane avec ladite portion en carte plane (44),
**caractérisé en ce que** ladite portion en carte non plane avec ladite portion en carte plane (44) définit soit une interface de carte (14) soit un réflecteur (50).

2. Dispositif d'éclairage (10) selon la revendication 1, dans lequel ladite interface de carte (14) et ledit réflecteur (50) sont tous les deux définis par ladite portion en carte non plane avec ladite portion en carte plane (44).

3. Dispositif d'éclairage (10) selon la revendication 1, dans lequel la carte à circuits inclut une couche diélectrique (22), une couche à circuits (24), et une couche supérieure isolante formant masque de soudure (26).

4. Dispositif d'éclairage (10) selon la revendication 3, comprenant en outre une couche de base thermoconductrice (20) qui évacue la chaleur et supprime les interférences électromagnétiques depuis la couche à circuits (24) et la couche diélectrique (22).

5. Dispositif d'éclairage (10) selon la revendication 3, dans lequel la couche à circuit (24) inclut une piste conductrice électrique pour alimenter en puissance un composant (16, 18) disposé sur la carte à circuit (12).

6. Dispositif d'éclairage (10) selon la revendication 5, dans lequel ledit composant (16) est défini de manière à inclure une ou plusieurs diodes électroluminescentes.

7. Dispositif d'éclairage (10) selon la revendication 6, dans lequel ladite carte à circuits (12) qui inclut lesdites une ou plusieurs diodes électroluminescentes (16) est adaptable pour remplacer un composant formant source de lumière incandescente, ou un agencement de circuit formant source de lumière incandescente.

8. Dispositif d'éclairage (10) selon la revendication 3, comprenant en outre une portion absente dans ladite couche supérieure isolante formant masque de soudure (26), qui expose une ou plusieurs portions de ladite couche à circuits (24) pour réaliser un ou plusieurs points ou patins de connexion (30, 32) afin de constituer des emplacements de connexion électrique et de montage en surface (36) pour un ou plusieurs composants de surface destinés à être attachés à ladite carte (12).

9. Dispositif d'éclairage (100, 200) selon la revendication 1, comprenant en outre : un connecteur (15), une ou plusieurs portions de sertissage (102, 202) s'étendant depuis des pattes (104, 204) des connecteurs (15) ; et une structure (112, 212) qui est reçue par un passage ou une ouverture (110, 210) définie par lesdites une ou plusieurs portions de sertissage (102, 202) qui augmente la rigidité du dispositif d'éclairage (100, 200) en stabilisant sur le plan structurel les connecteurs (15) par rapport à la carte (12).

10. Procédé pour fabriquer un dispositif d'éclairage (10), comprenant les étapes consistant à :
fournir une carte à circuits (12) avec une première portion et une seconde portion ; conformer la première portion pour définir une portion de carte à circuits (44) sensiblement plane ; et conformer la seconde portion en une portion de carte à circuits sensiblement non plane définie par une interface de carte (14), et un réflecteur (50).

11. Procédé selon la revendication 10, dans lequel l'étape de fourniture d'une carte à circuits (12) inclut l'étape consistant à prévoir une couche supérieure isolante formant masque de soudage (26).

12. Procédé selon la revendication 11, comprenant en outre l'étape consistant à prévoir une carte à circuits (24) qui inclut une piste électriquement conductrice pour alimenter en puissance un composant (16, 18).

13. Procédé selon la revendication 10, dans lequel ledit composant est défini comme incluant une ou plusieurs diodes électroluminescentes (16), et comprenant en outre l'étape consistant à remplacer un composant formant source de lumière incandescente ou un circuit formant source de lumière incandescente par ladite carte à circuits (12) incluant lesdites une ou plusieurs diodes électroluminescentes (16).

14. Procédé selon la revendication 11, comprenant en outre l'étape consistant à prévoir une portion absente sur la couche supérieure (26) ou à attaquer la couche supérieure (26) pour exposer une couche conductrice ou métallique disposée au-dessous de la couche supérieure (26) pour définir le réflecteur (50).

15. Procédé selon la revendication 11, comprenant en outre l'étape consistant à prévoir une couche de matériau réfléchissant sur la couche supérieure (26) pour définir le réflecteur (50).
